# EUROPÄISCHE PATENTSCHRIFT

(11) **EP 1 052 703 B1**
(45) Veröffentlichungstag und Bekanntmachung des Hinweises auf die Patenterteilung: **16.03.2011**
(21) Anmeldenummer: 00109199.0
(22) Anmeldetag: 09.05.2000
(51) Int. Cl.: H01L 31/032, H01L 31/0336, H01L 31/18

(54) **Dünnschichtsolarzelle auf der Basis der Ib/IIIa/VIa-Verbindungshalbleiter und Verfahren zum Herstellen einer solchen Solarzelle**
Thin film Ib/IIIa/VIa compound semiconductor solar cell and method of production of such a solar cell
Cellule solaire à couches minces à base du composé semiconducteur Ib/IIIa/VIa et méthode pour sa production

(30) Priorität: 10.05.1999 DE 19921515
(43) Veröffentlichungstag der Anmeldung: 15.11.2000
(73) Patentinhaber: ODERSUN Aktiengesellschaft, 15236 Frankfurt (Oder) (DE)
(72) Erfinder: Tober, Olaf, 10437 Berlin (DE); Penndorf, Jürgen, Dr., 15236 Hohenwalde (DE); Winkler, Michael, Dr., 12589 Berlin (DE); Jacobs, Klaus, Prof. Dr., 12559 Berlin (DE); Koschack, Thomas, Dr., 15295 Wiesenau (DE)
(74) Vertreter: Volpert, Marcus

(56) Entgegenhaltungen:
- WO-A-94/07269
- US-A- 5 477 088
- JACOBS K ET AL: "CISCuT- a non vacuum roll to roll technique for the preparation of copper indium chalcogenide absorber layers on a copper tape" 2ND WORLD CONFERENCE ON PHOTOVOLTAIC SOLAR ENERGY CONVERSION. / 15TH EUROPEAN PV SOLAR ENERGY CONFERENCE. / 27TH US IEEE PHOTOVOLTAICSSPECIALISTS CONFERENCE. / 10TH ASIA/PACIFIC PV SCIENCE AND ENGINEERINGCONFERENCE. VIENNA, AUSTRIA, JULY 6 - 10, 1998, Bd. VOL. 1, 6. Juli 1998 (1998-07-06), Seiten 409-412, XP002148778 ISBN: 92-828-5179-6

## Beschreibung

Die Erfindung bezieht sich auf eine Dünnschichtsolarzelle nach dem Oberbegriff des Patentanspruchs 1 sowie auf ein Verfahren zum Herstellen einer solchen Solarzelle nach dem Oberbegriff des Patentanspruchs 3.

Eines der wesentlichen Ziele der Entwicklung von Photovoltaikmodulen ist die deutliche Reduktion der solaren Stromgestehungskosten für terrestrische Anwendungen. Für extraterrestrische Anwendungen steht neben der Strahlungsresistenz der Solarzellen die Gewichtsreduzierung der Solarmodule im Mittelpunkt der Entwicklung.

Solarzellen und Module auf der Basis von polykristallinen Ib/IIIa/VIa-Verbindungshalbleitern sind geeignete Kandidaten, um diese Ziele zu erreichen. Insbesondere mit den Verbindungshalbleitem auf der Basis von Kupfer, Indium und Gallium sowie Selen bzw. Schwefel als photoaktives Absorbermaterial, die allgemein als CIS bzw. CIGS bezeichnet werden, wurden in den letzten Jahren große Fortschritte erzielt.

Die aus der US-A-5 141 564 bekannte Zellstruktur mit einem Glassubstrat, einer Molybdänrükkelektrode, einer 1 bis 5 µm dicken polykristallinen Absorberschicht aus CuInSe₂ oder CuIn(Se,S)₂ vom p-Leitungstyp, einer dünnen Cadmiumsulfid-Fensterschicht und einer transparenten Frontelektrode vom n-Leitungstyp bildet die Grundlage der meisten Verfahren zur Herstellung dieser polykristallinen Dünnschichtsolarzellen. Statt auf molybdänbeschichteten Glassubstraten können die polykristallinen Absorberschichten auch auf flexiblen bandförmigen Substraten wie Molybdänbändem oder molybdänbeschichteten Metallbändern, wie in den DE-C2- 42 25 385 und EP-A1-0 574 716 beschrieben, abgeschieden werden.

Allen diesen Anordnungen gemeinsam ist eine aus Molybdän bestehende Rückelektrode. Die geringe Haftfestigkeit der polykristallinen Absorberschichten auf Molybdän führt jedoch zur Ablösung der Schichten auf Glassubstraten und zu Abplatzungen auf flexiblen Bändern und hat die Entwicklung von flexiblen CIS-Solarzellen bisher stark behindert. Zur Verbesserung der Haftfestigkeit der CIS-Absorberschichten werden in der WO 95/09 441 Zwischenschichten aus Titan, Tantal, Chrom oder Titannitrid zwischen der Molybdänrückelektrode und der Absorberschicht vorgeschlagen. In der EP-A2-0 360 403 wird eine Kupfer-Indium-Diselenid Solarzelle mit einer galliumhaltigen Zwischenschicht zwischen dem CIS-Absorber und dem Molybdänsubstrat vorgeschlagen. In der EP-A2-0 798 786 wird eine Solarzelle mit einer Chalkopyritabsorberschicht vorgeschlagen, bei der zwischen der Molybdänrückelektrode und der Absorberschicht eine dünne Zwischenschicht angeordnet ist, die Zink enthält. Nachteilig bei all diesen Anordnungen ist die Einführung einer zusätzlichen Komponente und damit die Notwendigkeit eines zusätzlichen technologischen Schrittes zur Abscheidung dieser Schichten.

In der DE-C2-196 34 580 wird ein Verfahren vorgeschlagen, bei dem die CIS-Absorberschicht direkt auf ein Kupferband abgeschieden wird. Die CIS-Absorberschicht ist bei diesem Verfahren fest mit dem Kupferband verwachsen, so dass hier keine Ablösungen oder Abplatzungen auftreten. Zwischen dem Kupferband und der polykristallinen Absorberschicht wird in Solar Energy Materials and Solar Cells 53 (1998) 285-298 eine dünne Schicht intermetallischer Kupfer-Indium-Phasen nachgewiesen. Die nach diesem Verfahren hergestellte Absorberschicht ist vom n-Leitungstyp. Da die Beweglichkeit der Minoritätsladungsträger in n-leitenden Chalkopyriten um eine Größenordnung geringer als in p-leitenden ist, sind mit dieser Anordnung geringere Wirkungsgrade als bei der Anordnung mit einer p-Absorberschicht und einer n-leitenden Kollektorschicht zu erwarten. Des Weiteren wirkt sich bei diesem Verfahren die geringe mechanische Stabilität von Kupfer nachteilig aus, so dass relativ dicke Kupferbänder eingesetzt werden müssen. Da bei diesem Verfahren das Kupferband gleichzeitig die Kupferquelle für die Absorberschicht bildet, müssen sehr reine Kupferbänder eingesetzt werden, die die Solarzelle unnötig verteuern.

Weitere konventionelle Dünnschichtsolarzellen sind aus den folgenden Schriften bekannt:
US-A-5 477 088
JACOBS K ET AL: "CISCuT- a non vacuum roll to roll technique for the preparation of copper indium chalcogenide absorber layers on a copper tape" 2ND WORLD CONFERENCE ON PHOTOVOLTAIC SOLAR ENERGY CONVERSION. / 15TH EUROPEAN PV SOLAR ENERGY CONFERENCE. / 27TH US IEEE PHOTOVOLTAICSSPECIALISTS CONFERENCE. / 10TH ASIA/PACIFIC PV SCIENCE AND ENGINEERINGCONFERENCE. VIENNA, AUSTRIA, JULY 6 - 10, 1998, Bd. VOL. 1, 6. Juli 1998 (1998-07-06), Seiten 409-412, XP002148778 ISBN: 92-828-5179-6
WO 94/07269 A

Der Erfindung liegt die Aufgabe zugrunde, eine Solarzelle der eingangs erwähnten Art zu schaffen, die leichter und wirtschaftlicher handhabbar ist, insbesondere auf beliebigen kostengünstigen Trägerfolien fest haftet, flexibel, mit geringem Kostenaufwand produzierbar ist und ein sehr geringes Gewicht aufweist, sowie ein Verfahren zum Herstellen einer solchen Solarzelle anzugeben.

Diese Aufgabe wird erfindungsgemäß durch eine Solarzelle mit den Merkmalen des Patentanspruchs 1 und verfahrensseitig durch ein Verfahren mit den Merkmalen des Patentanspruchs 3 gelöst. Vorteilhafte Ausgestaltungen sind Gegenstand der jeweiligen Unteransprüche.

Grundlegende Idee der Erfindung ist es, die Rückelektrode der Solarzelle aus intermetallischen Phasen der gleichen Ib- und IIIa-Metalle, die für die Bildung der polykristallinen Absorberschicht verwendet werden, herzustellen. Diese intermetallischen Phasen dienen gleichzeitig der Haftvermittlung zwischen der Absorberschicht und der flexiblen Trägerfolie. Damit erübrigt sich die separate Abscheidung einer Molybdänschicht als Rückelektrode und die Abscheidung von Zwischenschichten zur Verbesserung der Haftfestigkeit der Absorberschicht.

Wegen der guten Haftfähigkeit der Absorberschicht können kostengünstige, sehr dünne, mechanisch feste Metallfolien als Substrat genutzt werden. Auf diesen Substraten können flexible Solarzellen in kontinuierlichen Rolle-zu-Rolle Prozessen hergestellt werden. In einem ersten Schritt werden dazu in einem kontinuierlichen Rolle-zu-Rolle Prozess die Ib- und IIIa-Metalle abgeschieden. In einem zweiten kontinuierlichen Rolle-zu-Rolle Prozess wird die mit dem Precursor beschichtete Trägerfolie in einem Schmalspaltreaktor chalkogenisiert. Der Prozess wird so geführt, dass der Ib/IIIa-Metallprecursor nur unvollständig in die ternäre, polykristalline p-Absorberschicht umgewandelt wird, so dass sich unmittelbar auf der Trägerfolie intermetallische Phasen der Ib- und IIIa-Metalle befinden, welche als Rückelektrode der Solarzellenstruktur dienen.

Aufgrund der kurzen Reaktionszeiten bei der Chalkogenisierung und der geringen Wärmekapazität der Trägerfolie lassen sich so auf effiziente Weise ternäre polykristalline Absorberschichten in einem kontinuierlichen Rolle-zu-Rolle Prozess auf dünne Trägerfolien abscheiden. Die polykristalline Absorberschicht ist mit der Rückelektrode fest verwachsen, so dass es weder zu Ablösungen noch zu Abplatzungen auf den flexiblen Metallfolien kommt. Die Abscheidung einer Bufferschicht und einer transparenten Frontelektrode in kontinuierlichen Rolle-zu-Rolle Verfahren vervollständigt den Prozess zur Herstellung dieser flexiblen Dünnschichtsolarzellen.

Die Erfindung wird nachfolgend anhand von zwei Ausführungsbeispielen erläutert. Die zugehörigen Zeichnungen zeigen:

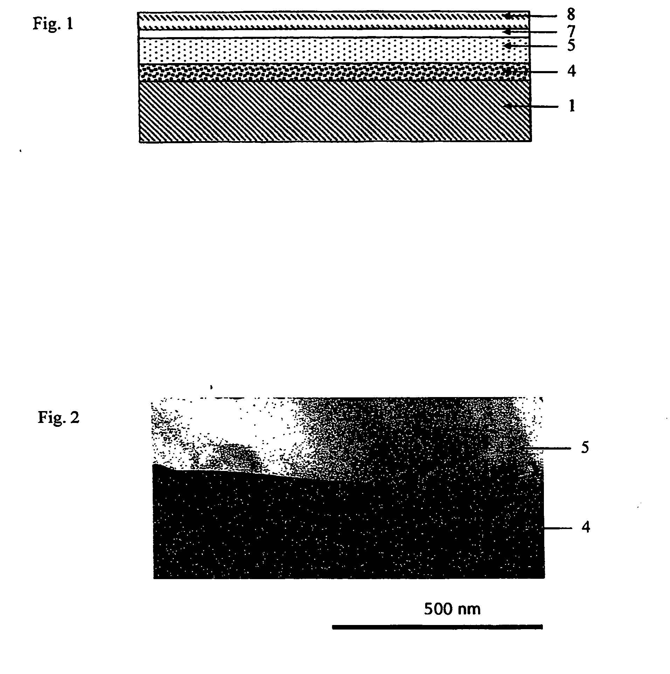

- Fig. 1: einen schematischen Aufbau einer Solarzelle;
- Fig. 2: eine vergrößerte Ansicht einer mit der Rückelektrode fest verwachsenen polykri - stallinen Absorberschicht; und

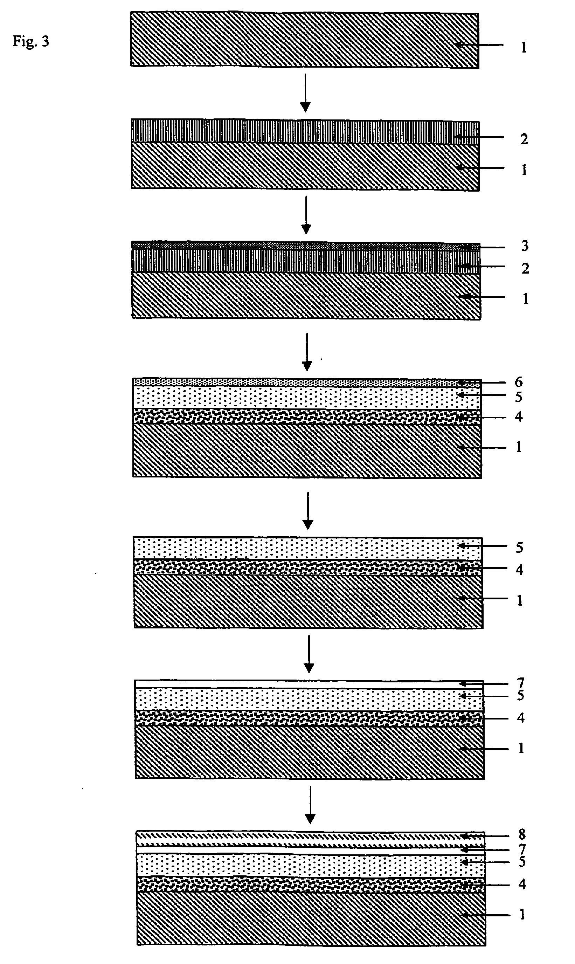

- Fig. 3: schematische Ansichten von Zwischenprodukten bei der Herstellung der flexiblen Solarzelle.

Als Trägerfolie 1 dient üblicherweise eine dünne, typischerweise 10 µm bis 30 µm dicke Stahlfolie, die zusätzlich mit anderen Metallen oder Oxiden beschichtet sein kann. Auf der Trägerfolie 1 befindet sich die 1 µm bis 5 µm dicke Rückelektrode 4, die aus der intermetallischen Phase Cu₇In₃ besteht. Darüber ist die polykristalline Absorberschicht (PAS) 5 vom p-Leitungstyp, aus der Phase CuInS₂ bestehend, angeordnet. Sie hat typischerweise eine Dicke von 1 µm bis 3 µm. Die PAS 5 ist fest mit der Rückelektrode 4 verwachsen, so dass es zu keinen Abplatzungen kommt. Auf der polykristallinen Absorberschicht 5 ist eine dünne Bufferschicht 7, vorzugsweise aus CdS, angeordnet. Diese Bufferschicht 7 hat eine Dicke von 10 nm bis 50 nm. Auf der Bufferschicht 7 befindet sich die transparente Ableitelektrode 8, vorzugsweise aus fremddotiertem Zinkoxid.

Diese Solarzelle ist nur etwa 20 µm bis 40 µm dick und lässt sich damit sehr materialeffizient herstellen. Sie ist mit ihrer geringen Schichtdicke sehr leicht und so für extraterrestrische Anwendungen bestens geeignet.

Um solche Solarzellen herzustellen, werden auf die flexible Stahlfolie 1, nacheinander vorzugsweise in einem Rolle-zu-Rolle Prozess, die Metalle Kupfer und Indium elektrolytisch abgeschieden. Dies ist ein sehr materialeffizientes und anlagentechnisch relativ einfaches Verfahren. Auch die Abscheidung des Metallprecursors durch Sputter- und Vakuumverdampfungsprozesse oder Kombinationen dieser Prozesse sind möglich. Die Kupferschicht 2 ist 1 µm bis 5 µm dick. Die Dicke der Indiumschicht 3 beträgt 0,5 µm bis 2 µm.

Danach wird die mit dem Cu/In-Precursor beschichtete Trägerfolie 1 in einem Rolle-zu-Rolle Prozess in einem Schmalspaltreaktor einige Sekunden chalkogenisiert. Der Precursor wird vorzugsweise im Millisekundenbereich auf 450 °C bis 600 °C unter Inertgasatmosphäre erhitzt. Das Indium schmilzt auf, das Kupfer wird laut Phasendiagramm in die Schmelze eingelöst. Anschließend wird der Precursor in schwefel- oder selenhaltigem Reaktionsgas, vorzugsweise in schwefelhaltigem Stickstoffträgergas, chalkogenisiert. Bei diesem Prozess wird die p-leitende polykristalline Absorberschicht 5 durch chemische Reaktion des gasförmigen Schwefels mit dem flüssigen Cu/In-Precursor gebildet. Die Chalkogenisierung dauert vorzugsweise 1 Sekunde bis 10 Sekunden. Bei dieser Prozessführung wird der Cu/In-Precursor nur unvollständig in die polykristalline Absorberschicht 5 umgewandelt. Nach der Chalkogenisierung wird die Folie 1 mit der Absorberschicht 5 unter Inertgasatmosphäre bei einer Temperatur von vorzugsweise 500 °C bis 600 °C getempert. Dieser Temperschritt dauert typischerweise 10 s bis 60 s. Dabei erstarrt der Restprecursor unter Bildung von intermetallischen Cu/In-Phasen, der Cu₇In₃- Phase, die die Rückelektrode 4 der Solarzelle bildet und gleichzeitig fest mit der Absorberschicht 5 verwächst. Die Temperung determiniert die kristalline Struktur und die elektronischen Eigenschaften der polykristallinen Absorberschicht 5. Nach der Temperung wird die Folie unter Inertgasatmosphäre im Sekundenbereich auf Raumtemperatur abgekühlt.

Der gesamte Prozeß "Aufheizung - Chalkogenisierung - Tempern - Abkühlung" dauert typischerweise zwischen 15 s und 70 s. Es entsteht die Struktur "Stahlfolie 1 - Cu/In Rückelektrode 4 - polykristalline p-CIS-Absorberschicht 5".

Auf der Oberfläche der CIS-Absorberschicht 5 können sich binäre Cu/Chalkogen-Phasen 6 gebildet haben, die in einem Zwischenschritt in einem Rolle-zu-Rolle Verfahren abgeätzt werden.

Auf die p-leitende polykristalline Absorberschicht 5 wird eine Cadmiumsulfidschicht in einem Rolle-zu-Rolle Verfahren nasschemisch abgeschieden. Die Abscheidung von dünnen Indiumoxid-, Indiumhydroxid- oder Zinksulfidschichten ist ebenfalls möglich.

In einem letzten Schritt wird eine transparente Deckelektrode (TCO) in einem Rolle-zu-Rolle Verfahren aufgebracht, die üblicherweise aus einer 1 µm bis 2 µm dicken ZnO-Schicht besteht und durch einen Sputterprozeß abgeschieden werden kann. Hier können auch andere leitfähige Oxide eingesetzt werden.

## Patentansprüche

1. Dünnschichtsolarzelle auf der Basis der Ib/IIIa/VIa-Verbindungshalbleiter,
**dadurch gekennzeichnet, dass**
zwischen der polykristallinen Ib/IIIa/VIa-Absorberschicht (5) aus CuInS₂ vom p-Leitungstyp und einer flexiblen Trägerfolie (1) aus Stahl, die als Substrat dient, eine Rückelektrode (4) aus der binären intermetallischen Phase Cu₇ln₃ der gleichen Ib- und IIIa-Metalle, die die Absorberschicht (5) bilden, angeordnet ist und
auf der polykristallinen Absorberschicht (5) eine dünne Pufferschicht (7) aus Cadmiumsulfid, Indiumoxid, Indiumhydroxid oder Zinksulfid, angeordnet ist.

2. Dünnschichtsolarzelle nach Anspruch 1, **dadurch gekennzeichnet, dass** die Trägerfolie (1) zwischen 15 µm und 100 µm dick ist.

3. Verfahren zum Herstellen einer Dünnschichtsolarzelle nach Anspruch 1 oder 2, **dadurch gekennzeichnet, dass**
- die Ib- und IIIa-Metalle aus Cu, In auf die flexible Trägerfolie (1) aus Stahl abgeschieden werden wobei zwest eine Kupferschnicht mit eines Dicke von 1 µm bis 5 µm und auschlieβend eine Indiumschnicht mit einer Dicke von 0,5 µm bis 2 µm aufgetragen wird,
- die Metalle Cu, In von der der Trägerfolie (1) abgewandten Seite her durch Reaktion mit Chalkogen vertikal nur unvollständig in die photovoltaisch aktive Absorberschicht (5) aus CuInS₂ vom p-Leitungstyp umgewandelt werden, so dass sich zwischen der Absorberschicht (5) und der Trägerfolie (1) die Rückelektrode (4) aus der intermetallischen Phase Cu₇ₗn₃ der gleichen Ib- und IIIa-Metalle bildet, welche zur Erzeugung der Absorberschicht (5) abgeschieden wurden,
- eine Pufferschicht (7) aus Cadmiumsulfid, Indiumoxid, Indiumhydroxid oder Zinksulfid abgeschieden wird und
- eine transparente leitfähige Frontelektrode (8) abgeschieden wird.

4. Verfahren nach Anspruch 3, **dadurch gekennzeichnet, dass** die Trägerfolie (1) mit der Absorberschicht (5) nach der Chalkogenisierung unter Inertgasatmosphäre vorzugsweise bei einer Temperatur von 500°C bis 600°C und einer Dauer von 10 s bis 60 s getempert wird.

5. Verfahren nach Anspruch 4, **dadurch gekennzeichnet, dass** die Dauer des gesamten Prozesses "Aufheizung-Chalkogenisierung-Tempern-Abkühlung" zwischen 15 s und 70 s beträgt.

6. Verfahren nach einem der Ansprüche 3 bis 5, **dadurch gekennzeichnet, dass** der Chalkogenisierungsprozess ein Rolle-zu-Rolle Verfahren ist.

## Claims

1. Thin-film solar cell based on Ib-IIIa-VIa compound semiconductors, **characterised in that** there is arranged, between the polycrystalline Ib-IIIa-VIa absorber layer (5) of CuInS₂ having p-type conduction and a flexible supporting foil (1) of steel which acts as a substrate, a back electrode (4) of the binary intermetallic phase Cu₇In₃ of the same Ib and IIIa metals as go to form the absorber layer (5), and a thin buffer layer (7) of cadmium sulphide, indium oxide, indium hydroxide or zinc sulphide is arranged on the polycrystalline absorber layer (5).

2. Thin-film solar cell according to claim 1, **characterised in that** the supporting foil (1) is between 15 µm and 100 µm thick.

3. Method of producing a thin-film solar cell according to claim 1 or 2, **characterised in that**
- the Ib and IIIa metals of Cu, In are deposited on the flexible supporting foil (1) of steel, a layer of copper of a thickness of from 1 µm to 5 µm being applied first and a layer of indium of a thickness of from 0.5 µm to 2 µm then being applied,
- from the side remote from the supporting foil (1), the metals Cu, In are converted vertically, by reaction with chalcogen, only incompletely into the photo-voltaically active absorber layer (5) of CuInS₂ having p-type conduction, the back electrode (4) of the binary intermetallic phase Cu₇In₃ of the same Ib and IIIa metals as were deposited to produce the absorber layer (5) thus being formed between the absorber layer (5) and the supporting foil (1),
- a buffer layer (7) of cadmium sulphide, indium oxide, indium hydroxide or zinc sulphide is deposited and
- a transparent, conductive, front electrode (8) is deposited.

4. Method according to claim 3, **characterised in that**, after the chalcogenising, the supporting foil (1), together with the absorber layer (5), is tempered in an atmosphere of inert gas, preferably at a temperature of 500°C to 600°C for a period of 10 s to 60 s.

5. Method according to claim 4, **characterised in that** the duration of the entire "heating-chalcogenising-tempering-cooling" process is between 15 s and 70 s.

6. Method according to one of claims 3 to 5, **characterised in that** the chalcogenising process is a roll-to-roll process.

## Revendications

1. Cellule solaire à couches minces à base du composé semi-conducteur Ib/IIIa/VIa,
**caractérisée en ce que**
entre la couche absorbante polycristalline Ib/IIIa/VIa (5) en CuInS₂ du type de conduction p et une feuille porteuse flexible (1) en acier, qui sert de substrat, est agencée une électrode postérieure (4) à partir de la phase intermétallique binaire Cu₇In₃ des mêmes métaux Ib et IIIa qui forment la couche absorbante (5), et
une mince couche tampon (7) en sulfure de cadmium, en oxyde d'indium, en hydroxyde d'indium ou en sulfure de zinc est agencée sur la couche absorbante polycristalline (5).

2. Cellule solaire à couche mince selon la revendication 1, **caractérisée en ce que** la feuille porteuse (1) a une épaisseur entre 15 µm et 100 µm.

3. Procédé pour la fabrication d'une cellule solaire à couche mince selon la revendication 1 ou 2,
**caractérisé en ce que**
- les métaux Ib et IIIa sont déposés à partir de Cu, In sur la feuille porteuse flexible (1) en acier, de telle manière que l'on applique tout d'abord une couche de cuivre avec une épaisseur de 1 µm à 5 µm et on dépose ensuite une couche d'indium d'une épaisseur de 0,5 µm à 2 µm,
- les métaux Cu, In sont convertis, depuis le côté détourné de la feuille porteuse (1) par réaction avec du chalcogène verticalement seulement incomplètement pour donner la couche absorbante active sur le plan photovoltaïque (5) en CuInS₂ du type de conduction p, de sorte qu'il se forme entre la couche absorbante (5) et la feuille porteuse (1) l'électrode postérieure (4) à partir de la phase intermétallique Cu₇In₃, des mêmes métaux lb et IIIa qui ont été déposés pour générer la couche absorbante (5),
- on dépose une couche tampon (7) en sulfure de cadmium, en oxyde d'indium, en hydroxyde d'indium ou en sulfure de zinc, et
- on dépose une électrode frontale conductrice transparente (8).

4. Procédé selon la revendication 3, **caractérisé en ce que** la feuille porteuse (1) avec la couche absorbante (5) est tempérée après la chalcogénisation sous une atmosphère de gaz inerte, de préférence à une température de 500° C à 600° C et une durée de 10 s à 60 s.

5. Procédé selon la revendication 4, **caractérisé en ce que** la durée du processus total "chauffage-chalcogénisation-températion-refroidis-sement" est entre 15 secondes et 70 secondes.

6. Procédé selon l'une des revendications 3 à 5, **caractérisé en ce que** le processus de chalcogénisation est un procédé de "rouleau à rouleau".
